# EUROPEAN PATENT SPECIFICATION

(11) **EP 2 151 052 B1**
(45) Date of publication and mention of the grant of the patent: **15.08.2012**
(21) Application number: 08759545.0
(22) Date of filing: 13.05.2008
(51) Int. Cl.: H03K 3/03, H03K 5/13, H03K 5/00

(54) **RING OSCILLATOR FOR PLLS**
RINGOSZILLATOR FÜR PHASENREGELKREISE
OSCILLATEUR EN ANNEAU POUR PLLS

(30) Priority: 16.05.2007 DE 102007023044; 26.12.2007 US 16685
(43) Date of publication of application: 10.02.2010
(73) Proprietor: TEXAS INSTRUMENTS DEUTSCHLAND GMBH, 85356 Freising (DE)
(72) Inventor: REFELD, Thomas, 85456 Wartenberg (DE); VANSELOW, Frank, 85395 Attenkirchen (DE)
(74) Representative: Holt, Michael
(86) International application number: PCT/EP2008/055841
(87) International publication number: WO 2008/138929

(56) References cited:
- US-A- 5 619 161
- US-A- 5 955 929
- US-A1- 2005 046 497

## Description

The present invention generally relates to a phase locked loop (PLL), more particularly, to a controllable ring oscillator with low phase noise.

High frequency integrated circuits based on CMOS technology, the use of which is widespread in today's electronic devices, require all kinds of clock generation circuits to handle clock distribution and clock synchronization. Synchronization is provided by on-chip oscillators locked by phase locked loop (PLL) or delay locked loop (DLL) circuits, which are generally well known in the art. A PLL includes a phase comparator, a charge pump, a loop filter, a bias generator, and a VCO. Typically, the VCO is implemented by a ring oscillator, which is made of a number of cascaded inverting delay stages connected into a ring. Each delay stage has an output connected to an input of a following stage and the output of the final delay stage is connected to the input of the first delay stage. The phase comparator compares an input clock signal with the output signal of the VCO, and determines the phase difference (which is actually rather a frequency difference). The charge pump provides charge pulses proportional to the phase difference, which are integrated on a capacitor to establish a control voltage. The control voltage on the capacitor is fed to the VCO in order to adjust the oscillation frequency to the frequency of the PLL input signal. However, an increasingly noisy environment of the PLL has created a high demand for noise resistive PLL architectures. The noise is typically in the form of supply and substrate noise causing the output clocks of a PLL to jitter from their ideal timing. The amount of input tracking jitter produced as a result of supply and substrate noise is directly related to how quickly the PLL can correct the output frequency. In order to minimize the jitter, the loop bandwidth should be set as high as possible. However, due to process technology factors and stability requirements the loop bandwidth usually remains well below the lowest operating frequency. In order to cope with the tradeoff, Maneatis discloses in "Low-Jitter Process-Independent DLL and PLL Based on Self-Biased Techniques", IEEE Journal of Solid State Circuits, Vol. 31, No.11, November 1996, a self-biased PLL. The self-biased PLL has a bandwidth that tracks the operating frequency. However, the biasing circuits used to adjust the PLL inject additional noise into the PLL.

US patent no. 5,955,929 describes a known VCO resistant to supply voltage noise, which includes a compensation circuit for each delay cell and a noise-immune reference current generator for providing a noise-immune bias current to the conditioning circuit of the VCO. Us patent no. 5,619,161 describes a differential charge pump having a common mode voltage contol which maintains the output terminal of the pump at a common mode voltage having a given relationship with respect to the voltage of the power supply. US patent application, US 2005/0046497 describes a synchronous clock generation circuit capable of ensuring wide lock-in range and attaining low jitter, whereby the number of delay stages serving as a digital PLL circuit is increased/decreased.

It is an object of the present invention to provide a ring oscillator having a large tunable frequency range, small phase noise and a large output swing.

Accordingly, a ring oscillator with a plurality of cascaded inverting delay stages is provided. Each delay stage includes a differential pair of input transistors, a variable resistive load coupled to each transistor, a differential output between the variable resistive load and the corresponding input transistor, a variable current source coupled to the differential pair of transistors for variably setting a bias current through the differential pair of transistors, and an input coupled to the variable resistive load and the variable current source for receiving an configuration signal, wherein the variable resistive load and the variable current source are changed in response to the configuration signal, such that the bias current increases, while the variable resistive load decreases and vice versa. A first variable capacitive load is coupled to the differential output of each delay stage. Also, the first variable capacitive load is changed in response to the configuration signal, such that the resistive load and the capacitive load decrease, while the variable bias current increases and vice versa.

Generally, the ring oscillator according to the present invention can be adjusted in a feed forward manner in order to match the specific operating requirements. Using a variable resistive load allows a greater output swing of each delay stage, as the swing is not limited by the gate voltage of variable loads implemented by transistors (e.g. as the delay stage suggested by Maneatis). The configuration signal used to adjust the ring oscillator is derived from the output signal of the phase comparator. However, instead of introducing additional biasing stages in order to allow a more flexible adjustment of the oscillation frequency and the bandwidth of the PLL, the oscillating frequency of the ring oscillator is directly adjusted by the configuration signal. Not only the resistive load is set by the configuration signal for a specific delay, but also the bias current in each delay stage is reconfigured. If the resistive load is decreased, the delay of each delay stage is reduced and the oscillation frequency increases. Increasing the current through the differential pair increases the transconductance of the input stage. This entails an improved tracking speed of the PLL. Accordingly, the present invention allows to adjust the bandwidth of the PLL and therewith the tracking speed of the PLL, if the frequency of the input signal to the PLL changes. The adapted bandwidth enables fast tracking of the input frequency and the phase noise introduced in the PLL is reduced. A flexible adjustment of the bandwidth is achieved without the self biasing circuits suggested by Maneatis. This reduces the number of noise sources in the loop and thereby the total phase noise.

Using a variable capacitive load in the manner described takes account of the additional parasitic capacitance added by switches (i.e. transistors), additional branches of load resistors and bias currents, or the like. The parasitic capacitance reduces the tuning range. Accordingly, this aspect of the invention provides that a specific amount of a capacitive load can be switched off, if tuned towards higher frequencies to compensate for increasing parasitic capacitances in order to enlarge the tuning range. The delay stage according to the present invention must be conceived to compensate the first capacitive load at the lowest oscillation frequency.

According to a preferred embodiment, the variable resistive load may be implemented to include a number of resistive elements to be selectively switched by the configuration signal. Likewise, the variable current source may preferably include a number of parallel branches to be selectively switched for adding up a current of each branch, such that the summed currents serve as the bias current through the differential pair. This aspect of the invention provides a simple, precise and effective way of implementing the variable current source and the variable resistive load. Furthermore, the ability to increase the tail current to the differential pair of transistors reduces the phase noise of the PLL.

According to a further preferred embodiment of the invention a second variable capacitive load may be provided, which is coupled to the differential output of each delay stage. The second variable capacitive load can adapted independently from the first capacitive load. An additional second variable capacitive load allows a better fine tuning of the ring oscillator. Any non-idealities of the components used can be compensated by adding a certain capacitance value to the load capacitance of each stage. This way, the ring oscillator can also be adjusted to behave in a specific manner (e.g. linearly) in response to the configuration signal. The first and the second variable capacitive loads may preferably include a number of capacitive elements to be selectively switched by the configuration signal. Using predefined capacitive elements allows to define precisely the total capacitive load or the additional capacitive load to be added it the oscillator is tuned in response to the configuration signal.

With a variable resistive load, a first and a second variable capacitive load and a variable current source consisting of resistive elements, capacitive elements and current branches, the input signal may preferably be a digital control signal. For digital control, the variable resistive load, the variable capacitive load and the bias current source can be implemented in quantized portions, which can be selectively switched. A coarse tuning of the oscillator can be achieved by varying the resistive load of a delay stage. For example, increasing the resistive load decreases the output frequency of the oscillator. The bias current and the first capacitive load compensate for deficiencies inflicted by a change of the resistive load. Fine tuning of the output frequency is then performed by varying the second capacitive load. So, in response to a change of the digital value of the input signal the resistive load is decreased by switching a specific quantized portion (i.e. for example switching a resistor in a branch to the total resistive load to increase the conductance of the load). Likewise, the capacitive load is decreased to compensate for the new resistive branch, and the bias current is increased by a corresponding specific quantized portion for the same change of the input signal. Accordingly, the swing of the output signals of the delay stages is maintained, which improves phase noise. For example, the digital control signal may include the same number of lines, as the number of resistive or first capacitive elements or current branches in the variable current source. If the resistive elements, the first capacitive elements and the parallel branches of the variable current source have binary weighted values, a very effective adjustment of the delay stages and the PLL is possible. The ring oscillator according to one or multiple of the aspects of the present invention as set out here above is particularly useful for a partially or entirely digitally implemented PLL.

Advantageously, the ring oscillator can be implemented in CMOS technology, which means that it can easily be integrated into existing integrated circuit design libraries.

Further advantages and characteristics of the invention ensue from the description below of a preferred embodiment, and from the accompanying drawings, in which:
- Figure 1 is a simplified block diagram of a PLL according to the prior art;
- Figure 2 is a schematic of a conventional differential delay stage for a ring oscillator;
- Figure 3 is a simplified schematic of a delay stage for a ring oscillator according to a first embodiment of the invention;
- Figure 4 is a simplified schematic of a delay stage for a ring oscillator according to a second embodiment of the invention; and
- Figure 5 is a simplified schematic of a variable current source for use in a ring oscillator according to the second embodiment of the invention.

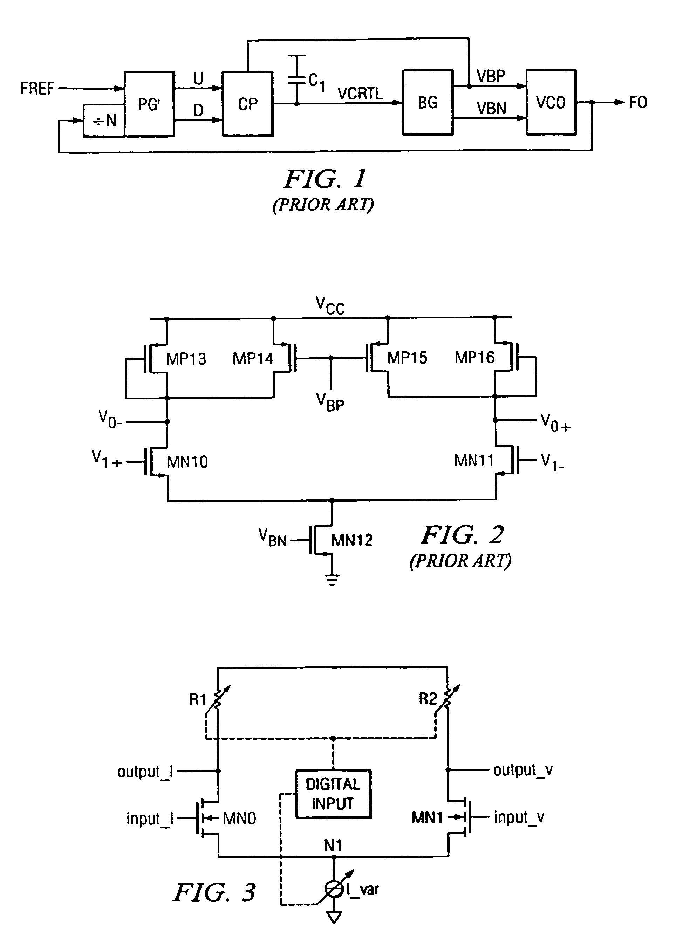

Figure 1 shows a simplified block diagram of a PLL according to the prior art. Accordingly, a phase comparator PC, a charge pump CP, a bias generator BG and a voltage controlled oscillator VCO are coupled in a loop. The output signal FO is coupled back and divided by an integer N. This signal is compared to the input signal VREF by the phase comparator PC and a respective output signal relating to the phase (or frequency) difference is fed to the charge pump CP. The charge pump produces charging pulses on the capacitance C1, which serves as the loop capacitance and provides a stable loop transfer function. The bias generator produces respective control signals VBP and VBN for the voltage controlled oscillator VCO based on the control voltage V_{CTRL}. The signals U and D produced by the phase comparator PC trigger the up (U) and down (D) pulses produced for the charge pump CP. In order to adjust the bandwidth of the PLL shown in Figure 1, an additional current path is directly coupled from the charge pump CP to VBP at the VCO. Due to the biasing and control mechanisms, additional phase noise is introduced into the loop impairing the overall performance of the PLL.

Figure 2 shows a simplified schematic of a delay stage to be used in a ring oscillator for a VCO as the one used in the PLL of Figure 1. The ring oscillator comprises cascaded inverting delay stages. Adjacent stages are connected so that an output of an upstream stage forms an input of a following downstream stage. The delay cell comprises a differential pair of transistors. In the delay stage shown in Figure 2, the differential pair comprises two n-channel MOS transistors, MN10 and MN11, having interconnected source terminals. The drain terminal of a further n-channel MOS transistor MN12 is connected to a node interconnecting the source terminals of the transistors MN10 and MN11. The source terminal of the transistor MN12 is connected to ground. The drain terminal of the transistor MN10 is connected to the gate and drain terminals of a p-channel MOS transistor MP13 and also to the drain terminal of another p-channel MOS transistor MP14. The drain terminal of the transistor MN11 is connected to the drain terminal of a p-channel MOS transistor MP15 and to the gate and drain terminals of a p-channel MOS transistor MP16. The gate terminals of the transistors MP14 and MP15 are interconnected and a node interconnecting the gate terminals of the transistors MP14 and MP15 is operable to receive a control voltage V_{CTRL}. The source terminals of the transistors MP13, MP14, MP15 and MP16 are all connected to a voltage rail Vcc. The gate terminal of the transistor MN10 is operable to receive an input voltage signal Vₗ₊ and the gate terminal of the transistor MN11 is operable to receive an input voltage signal Vₗ₋. The signals Vₗ₊ and Vₗ₋ are the output signals from the previous delay stage in the oscillator. There are two outputs from the delay stage; a first output terminal provided at the interconnection of the drain terminals of the transistors MN10, MP13 and MP14 and the gate terminal of the transistor MP13 and a second output terminal provided at the interconnection of the drain terminals of the transistors MN11, MP15 and MP16 and the gate terminal of the transistor MP16. The transistors MP13 and MP16 are diode connected transistors and they are used in combination with MP14 and MP15 to tune the ring oscillator to the desired frequency. Each delay stage of the ring oscillator has two of these transistor pairs for frequency tuning. However, phase noise is a problem with this conventional delay stage for several reasons. Frequency control is merely based on tuning the gate voltages V_{BP} of M14 and M15 and the gate voltage V_{BN} of MN12. V_{BN} and V_{BP} are derived from V_{CTRL}. V_{BN} is nominally equal to V_{CTRL}. Therefore, V_{CTRL} defines the lower voltage swing limit of the buffer outputs. Accordingly, the output swing of each delay stage is generally limited by the control voltage V_{CTRL}. The buffer delay changes with V_{CTRL}, since the effective resistance of the load elements also changes with V_{CTRL}. The NMOS current source MN12 is dynamically biased with V_{BN} to compensate for drain and substrate voltage variations, achieving the effective performance of a cascode current source. Accordingly, the current through current source MN12 is very stable. In order to adjust the bandwidth of the whole loop, the coupling between the charge pump CP (cf. Figure 1) and the VCO is to be modified as roughly indicated in Figure 1. In particular, additional biasing stages have to be inserted to provide higher flexibility, which inject additional noise into the loop.

Referring now to Figure 3, a delay stage for a ring oscillator according to a first embodiment of the invention comprises a differential pair of input transistors, in this case two n-type MOS transistors MN0 and MN1 having interconnected source terminals. A variable current source Iᵥₐᵣ is connected to an input node N1 interconnecting the source terminals of the transistors MN0 and MN1 and is adapted to be tuned by a control signal, so as to apply a variable bias current to the input node N1. The gate terminals of the transistors MN0 and MN1 are operable to receive input signals and are connected to input nodes input_l and input_r, respectively. The drain terminals of each of the transistors MN0 and MN1 are connected to separate output nodes output_l and output_r, respectively. The output nodes output_l and output_r are operable to output fully differential outputs; i.e., at any given time, output_r is the inverse of output_l, and vice versa, or both outputs equal zero. A variable resistor R1 is connected between the output node output_l and a voltage rail VDD, derived from the positive supply voltage, and a variable resistor R2 is connected between the output node output_r and the voltage rail VDD, so that each transistor is coupled to a variable resistive load. The variable resistors R1 and R2 are operable to be tuned by the same control signal used to tune the variable current source lᵥₐᵣ. As with the conventional delay stage, for a ring oscillator several of the delay stages shown in Figure 3 are connected together in the ring oscillator. The inputs input_l and input_r of an downstream delay stage are connected to the outputs output_l and output_r of an adjacent upstream delay stage. In operation, the current from the variable current source is proportionally routed through the transistors MN0 and MN1, depending on the size of the input voltages at input_l and input_r, respectively. The voltage signal at input_l is the inverse of the voltage signal at input_r and both signals are sine wave voltages having the same frequency and amplitude, but opposite polarity (i.e. opposite sign). The delay stage then produces a fully differential output signal at the outputs output_l and output_r. For tuning of the ring oscillator, the resistance of each of the variable resistors R1 and R2 and the bias current through the transistors MN0 and MN1 is varied by adjustment of the current source lᵥₐᵣ using the same signal as is used to tune the resistors R1 and R2. When the resistance of the resistors R1 and R2 is set to be high such that a large amount of the supply voltage is dropped across the resistors R1 or R2, the current source lᵥₐᵣ decreases the bias current to the transistors MN0 and MN1 by a corresponding amount so that the voltage drop across the resistors is substantially compensated for. In other words, each transistor, MN0 or MN1 is biased by an amount of current inversely proportional to the voltage drop across the corresponding resistor, R1 or R2, respectively. Using resistors R1, R2 as the load, generally allows to have larger output swing as with the symmetric PMOS loads shown in Figure 2. Also, as resistors have only very small 1/f noise (i.e. flicker or low frequency noise) compared with transistors, the overall noise of a delay stage is improved by use of load resistors. Maintaining a high output swing provides for a better ratio of output swing to noise of the delay stage, thereby improving phase noise. Further, controlling the bias current through the differential pair increases the transconductance of the input transistors of the differential pair. So, if the resistive load is decreased and the current is increased proportionally to the variation of the resistance in response to the same input signal, the oscillating frequency, the bandwidth and the tracking speed of the PLL may be adjusted proportionally to the value of the configuration signal. Particularly, by the present invention a substantially linear relation between the configuration signal and the oscillating frequency can be established. This allows a very efficient control of the oscillating frequency, which is helpful in particular for digital phase locked loops.

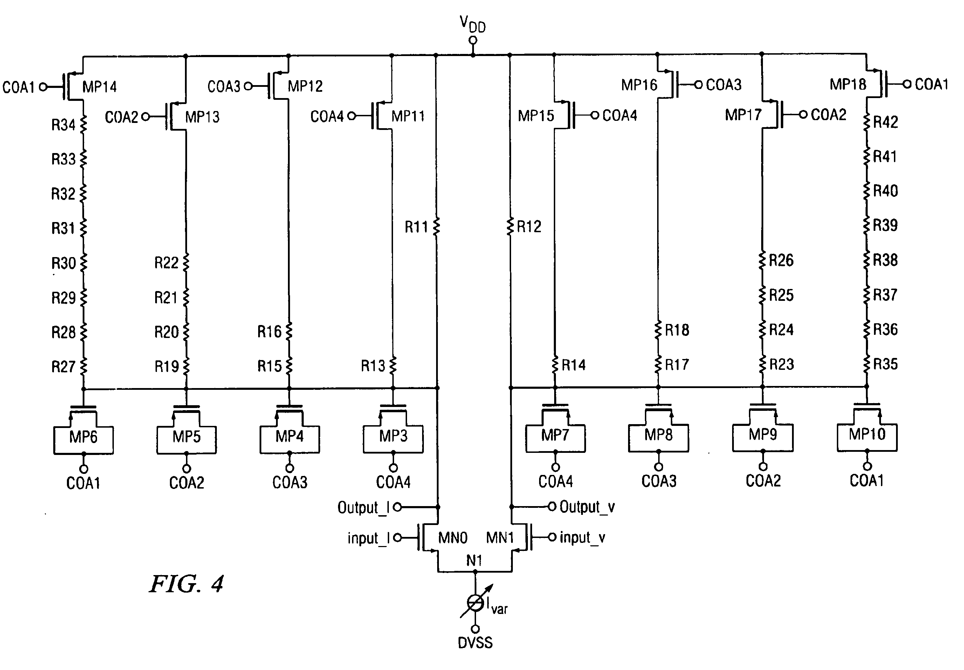

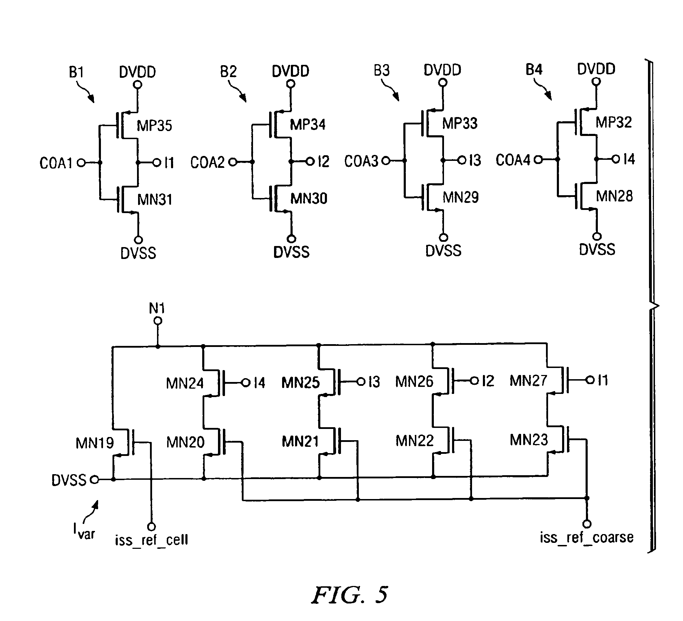

In the first embodiment, the resistors R1 and R2 allow a coarse tuning of the oscillator frequency so that the tuning step size is of the order of MHz. Figure 4 shows a delay stage for a ring oscillator according to a second embodiment of the invention, which allows digital coarse tuning of the frequency over a broad frequency range. The delay stage of Figure 4 provides that the resistive load and the bias current are binary weighted and switched in response to the same input signal. Further, a (first) capacitive load is provided that is also binary weighted and switched in response to the same digital input signal. The capacitive load is decreased while the resistive load is decreased and the bias current is increased. This first capacitive load compensates for parasitic capacitances in the resistive load and other circuit components. The delay stage comprises a differential pair of n-channel MOS transistors MN0 and MN1. Source terminals of the transistors MN0 and MN1 are both coupled to a node N1. A variable current source lᵥₐᵣ is connected between the node N1 and a voltage rail DVSS, derived from the negative supply voltage. The schematic of the current source is shown in Figure 5 and will be explained in detail later. The gate terminal of the transistor MN0 is connected to an input node input_l and the gate terminal of the transistor MN1 is connected to an input node input_r so that the gate terminals of the transistors MN0 and MN1 are operable to receive fully differential input voltage signals. The drain terminal of the transistor MN0 is connected to an output node output_l and the drain terminal of the transistor MN1 is connected to an output node output_r. The input nodes input_l and input_r are connected to the corresponding output nodes output_l and output_r, respectively of a previous upstream delay stage in the ring oscillator. Likewise, the output nodes output_l and output_r are connected to the corresponding input nodes input_l and input_r of the next downstream delay stage. The output node output_l is connected to a resistor R11 and the output node output_r is connected to a resistor R12. The resistance of the resistors R11 and R12 is fixed and equal. The resistors R11 and R12 are also both connected to a voltage rail VDD, derived from the positive supply voltage. Four branches of resistors are connected in parallel with the resistor R11 and a further four branches of resistors are connected in parallel with the resistor R12, so that there are eight branches of resistors altogether. Each branch of resistors comprises a binary weighted resistance. That is, the first branch comprises one resistor, the second two resistors connected in series, the third four resistors connected in series and the fourth eight resistors connected in series. Such an arrangement is provided on both sides of the delay stage; i.e., connected in parallel with the resistors R11 and R12, respectively. Each branch of resistors is connected between the drain terminal of a p-channel MOS transistor that acts as a switch and the gate terminal of p-channel MOS transistor that acts as a capacitive load. The branch closest to and connected in parallel with the resistor R11 comprises one resistor R13 connected between a p-type MOS transistor MP11 as the switching transistor and a p-type MOS transistor MP3 as the capacitive load. Connected in parallel with this branch are two resistors R15 and R16 connected in series between a p-type MOS transistors MP12 as the switch and a p-type MOS transistor MP4 as the capacitive load. The next parallel branch comprises four resistors R19-R22 connected in series between a p-type transistor MP13 as the switch and a p-type transistor MP5 as the capacitive load. The last branch connected in parallel with the transistor R11 comprises eight transistors R27-R34 connected in series between a p-type transistor MP14 as the switch and a p-type transistor MP6 as the capacitive load. The branch closest to and connected in parallel with the resistor R12 comprises one resistor R14 connected between a p-type MOS transistor MP15 as the switching transistor and a p-type MOS transistor MP7 as the capacitive load. Connected in parallel with this branch are two resistors R17 and R18 connected in series between a p-type MOS transistors MP16 as the switch and a p-type MOS transistor MP8 as the capacitive load. The next parallel branch comprises four resistors R23-R26 connected in series between a p-type transistor MP17 as the switch and a p-type transistor MP9 as the capacitive load. The last branch connected in parallel with the transistor R12 comprises eight transistors R35-R42 connected in series between a p-type transistor MP18 as the switch and a p-type transistor MP10 as the capacitive load. The resistors R11-R42 may be implemented as fixed resistors having the same size and value of resistance (unit resistors). The source terminals of the switching transistors MP11-MP18 are connected to the voltage rail VDD. Gate terminals of the switching transistors MP14 and MP18, and the source and drain terminals of the capacitive load transistors MP6 and MP10 are connected to an input node COA1; gate terminals of the switching transistors MP13 and MP17 and the source and drain terminals of the capacitive load transistors MP5 and MP9 are connected to an input node COA2; gate terminals of the switching transistors MP12 and MP16 and the source and drain terminals of the capacitive load transistors MP4 and MP8 are connected to an input node COA3; and, gate terminals of the switching transistors MP11 and MP15, and the source and drain terminals of the capacitive load transistors MP3 and MP7 are connected to an input node COA4.

The switching transistors MP11-MP18 can be all the same size; i.e., they have the same corresponding dimensions as each other. However, due to the different currents in the branches, it can be preferable to dimension the switching transistors in accordance with the requirements of each branch, i.e. they can also have binary weighted dimensions. The capacitive load transistors MP3-MP10 have binary weighted relative dimensions. The transistors MP6 and MP10 are the smallest, then the transistors MP5 and MP9 are twice the size of MP6 and MP10; MP4 and MP8 are four times the size of MP6 and MP10; and MP3 and MP7 are eight times the size of MP6 and MP10. The capacitance of each transistor corresponds to the size, so a larger transistor has a higher capacitance.

The current source lᵥₐᵣ will now be described with reference to Figure 5. It comprises five n-type MOS transistors MN 19-MN23 all having source terminals connected to the voltage rail DVSS. The drain terminal of the transistor MN19 is connected to the input node N1. Drain terminals of the transistors MN20-MN23 are respectively connected to source terminals of a further four n-type MOS transistors MN24-MN27. The drain terminals of the transistors MN24-MN27 are connected to the input node N1. The gate terminal of the transistor MN19 is connected to an input node ISS_ref_cell and the gate terminals of the transistors MN20-MN23 are connected to an input node ISS_ref_coarse. The gate terminals of the transistors MN24, MN25, MN26 and MN27 are connected to input nodes 14, 13, 12 and 11, respectively. The transistors MN19-MN23 all have the same corresponding dimensions but the transistors MN24-MN27 are weighted in size, with MN27 having the smallest dimensions; MN26 twice the size of MN27, MN25 four times the size of MN27 and MN24 eight times the size of MN27. A larger size corresponds to larger current.

The input signals to the nodes 11, 12, 13 and 14 are derived from the signals input to the input nodes COA1, COA2, COA3 and COA4, with each of the signals from the nodes COA1, COA2, COA3 and COA4 being inverted by an inverter B1, B2, B3 or B4, respectively, before being input to the input nodes l1, l2, l3 or 14. The inverter B1 comprises a complementary pair of MOS transistors MN31 and MP35 with interconnected drain terminals. The source terminal of the n-type transistor MN31 is connected to the voltage rail DVSS and the source terminal of the p-type transistor MP35 is connected to the voltage rail DVDD. The gate terminals of both transistors in the pair are connected to the input node COA1. The output of the inverter B1 is provided at a node interconnecting the drain terminals of the transistors MN31 and MP35 and is connected to the input node l1. The inverter B2 comprises a complementary pair of drain-connected MOS transistors MN30 and MP34. The source terminal of the n-type transistor MN30 is connected to the voltage rail DVSS and the source terminal of the p-type transistor MP34 is connected to the voltage rail DVDD. The gate terminals of both transistors in the pair are connected to the input node COA2. The output of the inverter B2 is provided at a node interconnecting the drain terminals of the transistors MN30 and MP34 and is connected to the input node l2. The inverter B3 comprises a complementary pair of MOS transistors MN29 and MP33 with interconnected drain terminals. The source terminal of the n-type transistor MN29 is connected to the voltage rail DVSS and the source terminal of the p-type transistor MP33 is connected to the voltage rail DVDD. The gate terminals of both transistors in the pair are connected to the input node COA3. The output of the inverter B3 is provided at a node interconnecting the drain terminals of the transistors MN29 and MP33 and is connected to the input node l3. The inverter B4 comprises an n-type transistor MN28 and a p-type transistor MP32. The drain terminals of the transistors MN28 and MP32 are interconnected. The source terminal of the n-type transistor MN28 is connected to the voltage rail DVSS and the source terminal of the p-type transistor MP32 is connected to the voltage rail DVDD. The gate terminals of both transistors in the pair are connected to the input node COA4. The output of the inverter B4 is provided at a node interconnecting the drain terminals of the transistors MN28 and MP32 and is connected to the input node l4.

For tuning the delay stage shown in Figure 4. the frequency of the output signals from the output node output_l and output_r is adjusted by varying the magnitude of the resistive and capacitive loads, and the bias current in the delay stage. Digital signals are applied to the input nodes COA1-COA4 so that the signal to the input nodes COA1-COA4 can either be low (0) or high (1) and each of the four branches of resistors symmetrically arranged either side of the resistors R11 and R12 can be switched separately, although the corresponding symmetrical branches are switched at the same time because they are connected to the same input node. Because the branches of resistors are connected in parallel, the resistance of the delay stage is at a minimum when all the branches are switched on and is at a maximum when the branches are switched off and only R11 and R12 contribute to the resistive load.

Signals are switched to the input nodes COA1-COA4 using a 4-bit word. That means that there are 16 possible values of resistive load in the delay stage. Taking the maximum and minimum values of resistance as an example, when the signals applied to the input nodes COA1-COA4 are all low; i.e., 0000, the input signals applied to the gates of the switching transistors MP11-MP18 are then low. This opens the p-channel in each of the transistors MP11-MP18 so that all branches of resistors are switched on and the resistance of the delay stage is at its minimum value. The frequency of an oscillator composed of respective delay stages would be maximum. The connected drain and source voltages of the capacitive load transistors MP3-MP10 are then low, too. Because the signal applied to the drain and source of the transistors MP3-MP10, from the input nodes COA1-COA4, is low, the capacitance of each of the transistors MP3-MP10 will be deactivated and the capacitance of the delay stage will be at its minimum value. At the same time, the input signals to the input nodes, l4, l3, l2 and l1 respectively connected to the gate terminals of the transistors MN24-MN27 are high, since they are the inverse of the signals applied to the nodes COA4, COA3, COA2 and COA1, respectively. This means that the n-channels of all the transistors MN24-MN27 are open and the current applied to the input node N1 from the current source lᵥₐᵣ is at its maximum value.

Conversely, when all the signals at the input nodes COA1-COA4 are high so that the 4-bit word configuration is 1111, the p-channels in the transistors MP14-MP18 remain closed and none of the branches of resistors are switched on. The resistance of the delay stage is then at its maximum value because only the resistors R11 and R12 contribute towards the resistive load. The drain and source voltages of the capacitive load transistors MP3-MP10 are then high, too. So, the p-channels in these transistors remain closed and the capacitance of the delay stage is at its maximum value. The current supplied to the input node N1 from the current source lᵥₐᵣ is at a minimum in this case because the signals input to the nodes l1-l4, the inverse of the signals input to the nodes COA1-COA4 are low, which means that the gate voltages of the transistors MN24-MN27 are low and therefore the n-channels of the transistors MN24-MN27 are all closed. All digital combinations of resistive load value between those resulting from the 0000 and the 1111 states of the input signals COA1-COA2 are possible, with the bias current to the input node N1 and the capacitance also varying accordingly. In other words, when all of the resistive branches are switched off, all of the capacitive load transistors MP3-MP10 are switched on. As resistive branches are successively switched on, the corresponding capacitive load transistor in each branch is switched off, so that the capacitive load transistors are effectively "ballast" used to balance the parasitic capacitance of the resistive branches.

When the conductance of the total resistive load of the delay stage is at a maximum, the delay of the delay stage is minimum and the frequency of an oscillator consisting of respective delay stages would be maximum. The opposite happens when the conductance of the resistive load of the delay stage is at a minimum.

A second capacitive load, also binary weighted and conceived in the same way as the first capacitive load described here above, could additionally be coupled to the output of each delay stage. The control of the second capacitive load could preferably be performed independently from the other the first capacitive load. The second capacitive load may then be used for fine tuning of the oscillator.

## Claims

1. A ring oscillator, comprising a plurality of cascaded inverting delay stages, each delay stage comprising:
a differential pair of input transistors (MN0, MN1),
a variable resistive load coupled to each transistor (R11...R42),
a differential output (Output _l, Output_r) between the variable resistive load and the corresponding input transistor,
a variable current source (lvar) coupled to the differential pair of transistors (MN0, MN1) for variably setting a bias current through the differential pair of transistors, and
an input (COA1...COA4) coupled to the variable resistive load (R11...R42) and the variable current source (lvar) for receiving an configuration signal, wherein
the variable resistive load (R11...R42) and the variable current source (lvar) are changed in response to the configuration signal, such that the bias current provided by the variable current source increases, while the variable resistive load decreases and vice versa; and
a first variable capacitive load (MP3...MP10) coupled to the differential output (Output _l, Output_r) of each delay stage;
**characterised in that**
the variable capacitive load is changed in response to the configuration signal, such that the capacitive load decreases, while the bias current provided by the variable current source (lvar) increases and vice versa.

2. The ring oscillator according to claim 1, wherein the variable capacitive load comprises a number of capacitive elements (MP3...MP10) to be selectively switched by the configuration signal.

3. The ring oscillator according to claim 1 or 2, wherein the variable resistive load comprises a number of resistive elements (R11...R42) to be selectively switched by the configuration signal.

4. The ring oscillator according to any one of the previous claims, wherein the variable current source (lvar) comprises a number of parallel branches (Fig.5) to be selectively switched for adding up a current of each branch, such that the summed currents serve as the bias current through the differential pair (MN0, MN1).

5. The ring oscillator according to one of the previous claims, comprising further a second variable capacitive load (MP3...MP10) coupled to the differential output (Output _I, Output_r) of each delay stage, wherein the second variable capacitive load can be changed in response to the configuration signal.

6. The ring oscillator according to claim 5, wherein the second variable capacitive load comprises a number of capacitive elements (MP3...MP10) to be selectively switched by the configuration signal.

7. The ring oscillator according to one of the previous claims, wherein the configuration signal is a digital control signal.

8. The ring oscillator according to claim 6 or 7 when dependent on claims 3 and 4, wherein the resistive elements (R11...R42), the capacitive elements (MP3...MP10) and the parallel branches (Fig.5) of the variable current source (lvar) have binary weighted values.

9. A phase locked loop comprising a ring oscillator according to one of the previous claims.

## Patentansprüche

1. Ein Ringoszillator, bestehend aus einer Vielzahl von kaskadierten invertierenden Verzögerungsstufen, jede Verzögerungsstufe bestehend aus:
einem Differenzialpaar von Eingangstransistoren (MN0, MN1),
einer regelbaren resistiven Last gekoppelt zu jedem Transistor (R11...R42),
einem Differenzialausgang (Output_l, Output_r) zwischen der regelbaren resistiven Last und dem entsprechenden Eingangstransistor,
einer regelbaren Stromquelle (lvar) gekoppelt zum Differenzialpaar von Transistoren (MN0, MN1), um der Vormagnetisierungsstrom durch den Differenzialpaar von Transistoren variabel zu regeln, und
einem Eingang (COA1,"COA4) gekoppelt zur regelbaren resistiven Last (R11...R42) und zur regelbaren Stromquelle (lvar), um ein Anordnungssignal zu bekommen, wobei
die regelbare resistive Last (R11...R42) und die regelbare Stromquelle (lvar) in Reaktion auf das Anordnungssignal verändert werden, damit der Vormagnetisierungsstrom , der durch die regelbare Stromquelle geliefert wird, größer wird, während die regelbare resistive Last kleiner wird und vice versa; und
einer ersten variablen kapazitiven Last (MP3...MP10) gekoppelt zum Differenzialausgang (Output_l, Output_r) von jeder Verzörgerungsstufe, **dadurch gekennzeichnet, daß** die variable kapazitive Last in Reaktion auf ein Anordnungssignal geregelt wird, damit die kapazitive Last kleiner wird, während der Vormagnetisierungsstrom, der durch die regelbare Stromquelle (lvar) geliefert wird, größer wird, und vice versa.

2. Der Ringoszillator nach Anspruch 1, wobei die regelbare kapazitive Last aus mehreren kapazitiven Elementen (MP3...MP10) besteht, die von dem Anordnungssignal selektiv geschaltet werden.

3. Der Ringoszillator nach Ansprüchen 1 oder 2, wobei die regelbare resistive Last aus mehreren resistiven Elementen (R11...R42) besteht, die von dem Anordnungssignal selektiv geschaltet werden.

4. Der Ringoszillator nach allen vorhergehenden Ansprüchen, wobei die regelbare Stromquelle (lvar) aus mehreren parallelen Armen (Fig. 5) besteht, die selektiv geschaltet werden, um der Strom von jedem Arm zusammenzurechnen, damit die zusammengerechnete Ströme als den Vormagnetisierungsstrom durch das Differenzialpaar (MN0, MN1) dienen.

5. Der Ringoszillator nach einem der vorhergehenden Ansprüchen, besteht dazu aus einer zweiten regelbaren kapazitiven Last (MP3...MP10) gekoppelt zum Differenzialausgang (Output_l, Output_r) von jedem Verzörgerungsstufe, wobei die zweite variable kapazitive Last in Reaktion auf das Anordnungssignal geregelt werden kann.

6. Der Ringoszillator nach Anspruch 5, wobei die zweite regelbare kapazitive Last aus mehreren kapazitiven Elementen (MP3...MP10) besteht, die durch das Anordnungssignal selektiv geschaltet werden.

7. Der Ringoszillator nach einem der vorhergehenden Ansprüchen, wobei das Anordnungssignal ein digitales Steuersignal ist.

8. Der Ringoszillator nach Ansprüchen 6 oder 7, wenn abhängig von Ansprüchen 3 und 4, wobei die resistive Elementen (R11...R42), die kapazitive Elementen (MP3...MP10) und die parallele Armen (Fig. 5) der regelbaren Stromquelle (lvar) binäre bewertete Werten haben.

9. Ein Phasenregelkreis bestehend aus einem Ringoszillator nach einem der vorhergehenden Ansprüchen.

## Revendications

1. Un oscillateur en anneau, comprenant une pluralité d'étapes de délai invertissant en cascade, chaque étape de délai comprenant :
une paire différentielle de transistors d'entrée (MN0, MN1),
une charge résistive variable couplée à chaque transistor (R11...R42),
une sortie différentielle (Output_l, Output_r) entre la charge résistive variable et le transistor d'entrée correspondant ,
une source de courant variable (lvar) couplée à la paire différentielle de transistors (MN0, MN1) pour régler variablement un courant de polarisation traversant la paire différentielle de transistors, et
une entrée (COA1...COA4) couplée à la charge résistive variable (R11...R42) et la source de courant variable (lvar) pour recevoir un signal de disposition, où
la charge résistive variable (R11...R42) et la source de courant variable (lvar) sont changées en réponse au signal de disposition, pour que le courant de polarisation fourni par la source de courant variable augmente, pendant que la charge résistive variable diminue et vice versa ; et
une première charge capacitive variable (MP3...MP10) couplée à la sortie différentielle (Output_l, Output_r) de chaque étape de délai , **caractérisée en ce que** la charge capacitive variable est changée en réponse au signal de disposition, pour que la charge capacitive diminue, pendant que le courant de polarisation fourni par la source de courant variable (Ivar) augmente, et vice versa.

2. L'oscillateur en anneau selon la revendication 1, où la charge capacitive variable comprend un nombre d'éléments capacitifs (MP3...MP10) pour être commuté sélectivement par le signal de disposition.

3. L'oscillateur en anneau selon les revendications 1 ou 2, où la charge résistive variable comprend un nombre d'éléments résistifs (R11...R42) pour être commuté sélectivement par le signal de disposition.

4. L'oscillateur en anneau selon les revendications précédentes, où la source de courant variable (lvar) comprend un nombre de branches parallèles (Fig. 5) pour être commuté sélectivement pour additionner un courant de chaque branche, pour que les courants additionnés servent comme le courant de polarisation traversant la paire différentielle (MN0, MN1).

5. L'oscillateur en anneau selon une des revendications précédentes, comprenant en outre une deuxième charge capacitive variable (MP3...MP10) couplée à la sortie différentielle (Output_l, Output_r) de chaque étape de délai, où la deuxième charge capacitive variable peut être changée en réponse au signal de disposition.

6. L'oscillateur en anneau selon la revendication 5, où la deuxième charge capacitive variable comprend un nombre d'éléments capacitifs (MP3...MP10) pour être commuté sélectivement par le signal de disposition.

7. L'oscillateur en anneau selon les revendications précédentes, où le signal de disposition est un signal numérique de commande.

8. L'oscillateur en anneau selon les revendications 6 ou 7, étant dépendant des revendications 3 et 4, où les éléments résistifs (R11...R42), les éléments capacitifs (MP3...MP10) et les branches parallèles (Fig.5) de la source de courant variable (lvar) ont les valeurs pondérées binaires.

9. Une boucle à verrouillage de phase comprenant un oscillateur en anneau selon une des revendications précédentes.
